(19) Europäisches Patentamt
European Patent Office
Office européen des brevets

(11) **EP 2 039 715 A1**

(12) **EUROPEAN PATENT APPLICATION**
published in accordance with Art. 153(4) EPC

(43) Date of publication:
**25.03.2009 Bulletin 2009/13**

(51) Int Cl.:
*C08G 73/10* (2006.01)    *B32B 15/088* (2006.01)
*B32B 27/34* (2006.01)

(21) Application number: **07767859.7**

(22) Date of filing: **29.06.2007**

(86) International application number:
**PCT/JP2007/063072**

(87) International publication number:
**WO 2008/004496 (10.01.2008 Gazette 2008/02)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **06.07.2006 JP 2006186355**
**08.12.2006 JP 2006331490**

(71) Applicant: **Toray Industries, Inc.**
**Tokyo, 103-8666 (JP)**

(72) Inventors:
• **KASUMI, Kenichi**
  **Otsu-shi, Shiga 520-8558 (JP)**
• **MATSUMURA, Nobuo**
  **Otsu-shi, Shiga 520-8558 (JP)**

(74) Representative: **Leissler-Gerstl, Gabriele et al**
**Hoefer & Partner**
**Patentanwälte**
**Pilgersheimer Strasse 20**
**81543 München (DE)**

(54) **THERMOPLASTIC POLYIMIDE, AND LAMINATED POLYIMIDE FILM AND METAL FOIL-LAMINATED POLYIMIDE FILM USING THE THERMOPLASTIC POLYIMIDE**

(57) Disclosed is a thermoplastic polyimide which has excellent heat resistance and can adhere to a metal foil by thermocompression bonding for a short-time. The thermoplastic polyimide comprising a tetracarboxylic dianhydride residue and a diamine residue wherein the biphenyl tetracarboxylic dianhydride residues account for 80 mol% or more of the total tetracarboxylic dianhydride residues, the 4,4'-diaminodiphenyl ether residues for 65 mol% or more and 85 mol% or less of the total diamine residues, and the paraphenylene diamine residues for 15 mol% or more and 35 mol% or less of the total diamine residues.

**Description**

Technical field

The present invention relates to a thermoplastic polyimide, a polyimide film laminate made thereof, a production process therefor, and a metal foil clad polyimide film laminate made thereof.

Background art

With high heat resistance and good mechanical characteristics, polyimide film is used in a wide variety of industrial fields including electronic apparatus. In particular, metal foil clad polyimide film laminates produced by thermocompression bonding of polyimide film and metal foil are desirably used as material for flexible printed circuit boards. Adhesives comprising thermosetting resin, such as epoxy adhesive, or thermoplastic polyimide are generally used to adhere polyimide film and metal foil by thermocompression bonding. Metal foil clad polyimide film laminates comprising thermoplastic polyimide used as adhesive are high in heat resistance and flexibility and therefore, used as highly functional metal foil clad polyimide film laminates.

A metal foil clad polyimide film laminate produced by thermocompression bonding of a polyimide film comprising a biphenyl tetracarboxylic acid component and an aromatic diamine component with metal foil has been proposed (for instance, see Patent document 1). A process to produce a heat-adhesive polyimide film by multilayer extrusion of a polyimide substrate with thermoplastic polyimide has also been proposed (for instance, see Patent documents 2-3). The thermoplastic polyimide materials proposed in these documents, however, have a high glass transition temperature, requiring high-temperature, lengthy thermocompression for bonding with metal foil.

To solve these problems, a multilayer polyimide comprising a polyimide layer of a specific structure has been proposed (for instance, see Patent document 4). High temperature heat treatment at 360˚C or above is effective to increase the rupture elongation of the polyimide substrate. The thermoplastic polyimide of a specific structure proposed in the document, however, is easily degraded at a high temperature, and therefore, heat treatment at a high temperature will decrease the strength of adhesion with the metal foil. This limits the temperature for heat treatment to 350˚C or below. Thus, it is difficult for generally known conventional multilayer polyimide films to achieve a high rupture elongation and a high adhesive strength simultaneously.

On the other hand, the process comprising multilayer extrusion of a polyimide substrate with heat adhesive polyimide can produce a low-warp polyimide film laminate with heat adhesive polyimide on both surfaces. However, there is a problem that an attempt to produce a polyimide film laminate with heat adhesive polyimide on only one side will results in a laminate with large warp. A polyimide film laminate with a heat-adhesive polyimide layer on one side and a non-heat-adhesive polyimide layer on the other side has been proposed as the means to produce a low-warp polyimide film laminate with a heat-adhesive polyimide layer on only one side. For instance, the use of a polyimide-based resin with a glass transition temperature of 60˚C or above that is higher than that of the adhesion layer as non-adhesive resin layer has been proposed (for instance, see Patent document 5). Another proposal is a flexible laminate comprising a non-adhesive layer of a polyimide resin that is produced by converting polyamic acid using an imidization accelerator (for instance, see Patent document 6).

[Patent document 1] U.S. Patent No. 4411952, Description
[Patent document 2] European Patent Application Publication No. 431636, Description
[Patent document 3] U.S. Patent No. 5262227, Description
[Patent document 4] U.S. Patent No. 5741598, Description
[Patent document 5] Japanese Unexamined Patent Publication (Kokai) No. 2000-96010 (pages 3-7)
[Patent document 6] Japanese Unexamined Patent Publication (Kokai) No. 2005-186274 (pages 4-13)

Disclosure of the invention

Problems to be solved by the invention

In view of the above problems, the present invention aims to provide a thermoplastic polyimide that is resistant to thermal degradation and can be adhered to metal foil by short-time thermocompression bonding and also provides a polyimide film laminate that is high in rupture elongation and high in strength of adhesion to metal foil by using said thermoplastic polyimide.

Means of solving the problems

The present invention relates to a thermoplastic polyimide comprising a tetracarboxylic dianhydride residue and a diamine residue wherein the biphenyl tetracarboxylic dianhydride residues account for 80 mol% or more of the total tetracarboxylic dianhydride residues, the 4,4'-diaminodiphenyl ether residues for 65 mol% or more and 85 mol% or less of the total diamine residues, and the paraphenylene diamine residues for 15 mol% or more and 35 mol% or less of the total diamine residues.

Effect of the invention

The present invention makes it possible to obtain a thermoplastic polyimide that is resistant to thermal degradation and low in glass transition temperature and can be adhered to metal foil by short-time thermocompression bonding. Polyimide film laminates produced from the thermoplastic polyimide of the present invention can be heat-treated at a high temperature of 360˚C or above and therefore has a high rupture elongation.

Best mode for carrying out the invention

The thermoplastic polyimide of the present invention is characterized by comprising tetracarboxylic dianhydride residue and diamine residue wherein the biphenyl tetracarboxylic dianhydride residues account for 80 mol% or more of the total tetracarboxylic dianhydride residues, the 4,4'-diaminodiphenyl ether residues for 65 mol% or more and 85 mol% or less of the total diamine residues, and the paraphenylene diamine residues for 15 mol% or more and 35 mol% or less of the total diamine residues. A thermoplastic polyimide containing tetracarboxylic dianhydride residue and diamine residue at such a specific ratio specifically has a low glass transition temperature in the range of 250 to 260˚C, leading to improved adhesion to metal foil by short-time thermocompression bonding. It is also possible to obtain thermoplastic polyimide that does not suffer degradation at a temperature of 360˚C or above. Consequently, the polyimide film laminate using the thermoplastic polyimide of the present invention can be heat-treated at a high temperature of 360˚C or above and can be laminated with metal foil in a short-time under continuously thermocompression bonding.

For the thermoplastic polyimide of the present invention, it is important that biphenyl tetracarboxylic dianhydride residues account for 80 mol% or more of the total tetracarboxylic dianhydride residues. If the fraction of biphenyl tetracarboxylic dianhydride residue is less than 80 mol%, the glass transition temperature will be too high, and it will be impossible to laminate with metal foil in a short-time under continuous thermocompression bonding. Heat treatment at high temperature, in addition, will lead to degradation, and high adhesive strength will not be achieved by thermocompression bonding with metal foil, making it impossible to obtain both good film characteristics and strong adhesion simultaneously. The fraction should preferably be 90 mol% or more, more preferably 100 mol%. Biphenyl tetracarboxylic dianhydride residues include 3,3',4,4'-biphenyl tetracarboxylic dianhydride residue, 2,3,3',4'-biphenyl tetracarboxylic dianhydride residue, and 2,2',3,3'-biphenyl tetracarboxylic dianhydride residue. 3,3',4,4'-biphenyl tetracarboxylic dianhydride residue is preferably used because the glass transition temperature of thermoplastic polyimide can be adjusted easily to a preferable range.

Residues of other tetracarboxylic dianhydrides including pyromellitic dianhydride, 3,3',4,4'-benzophenone tetracarboxylic dianhydride, 2,3',3,4'-benzophenone tetracarboxylic dianhydride, 2,2',3,3'-benzophenone tetracarboxylic dianhydride, 3,3',4,4'-diphenyl ether tetracarboxylic dianhydride, 2,3',3,4-diphenyl ether tetracarboxylic dianhydride, 2,2',3,3'-diphenyl ether tetracarboxylic dianhydride, 3,3',4,4'-diphenyl sulfone tetracarboxylic dianhydride, 2,3',3,4-diphenyl sulfone tetracarboxylic dianhydride, 2,2',3,3'-diphenyl sulfone tetracarboxylic dianhydride, and 4,4'-(hexafluoroisopropylidene)diphthalic dianhydride may be contained if their fraction is less than 20 mol%.

For the thermoplastic polyimide of the present invention, it is also important that the 4,4'-diaminodiphenyl ether residues account for 65 mol% or more and 85 mol% or less of the total diamine residues, and that the paraphenylene diamine residues account for 15 mol% or more and 35 mol% or less of the total diamine residues. If the fraction of the 4,4'-diaminodiphenyl ether residues is more than 85 mol% while that of the paraphenylene diamine residues is less than 15 mol%, the glass transition temperature will be too high, and it will be impossible to achieve adhesion with metal foil by short-time thermocompression bonding. If the fraction of the 4,4'-diaminodiphenyl ether residues is less than 65 mol% while that of the paraphenylene diamine residues is more than 35 mol%, the glass transition temperature will be too high, and it will be impossible to achieve adhesion with metal foil by short-time thermocompression bonding. That is, a thermoplastic polyimide specifically having a glass transition temperature of 250˚C or above and 260˚C or below can be obtained by adjusting the fraction of diamine residues to the above-mentioned range. The total of the 4,4'-diaminodiphenyl ether residues and the paraphenylene diamine residues accounts for 80 mol% or more of the total diamine residues, but should preferably be 100 mol% for more effective prevention of thermal degradation.

Other diamine residues may be contained if their fraction is less than 20 mol%. Said other diamine residues include those of methaphenilene diamine, 2,5-diaminotoluene, 2,4-diaminotoluene, 2-methoxy-1,4-phenylene diamine, 3,4'-diaminobenzanilide, 3,3'-diaminobenzanilide, 4,4'-diaminobenzanilide, 2'-methyl-4,4'-diaminobenzanilide, 2'-methoxy-4,4'-diaminobenzanilide, benzidine, 2,2'-dimethyl-4,4'-diaminobiphenyl, 3,3'-dimethyl-4,4'-diaminobiphenyl, 2,2'-dimethoxy-4,4'-diaminobiphenyl, 3,3'-dimethoxy-4,4'-diaminobiphenyl, 2,2'-ditrifluoromethyl-4,4'-diaminobiphenyl, 3,3'-ditrifluoromethyl-4,4'-diaminobiphenyl, 3,3'-diaminodiphenyl ether, 3,4'-diaminodiphenyl ether, 4,4'-diaminodiphenyl sulfone, 3,3'-diaminodiphenyl sulfone, 3,4'-diaminodiphenyl sulfone, 4,4'-diaminodiphenyl methane, 3,3'-diaminodiphenyl methane, 3,4'-diaminodiphenyl methane, 4,4'-diaminobenzophenone, 3,3'-diaminobenzophenone, 3,4'-diaminobenzophenone, 4,4'-diaminodiphenyl sulfide, 2,2-bis(4-aminophenyl) propane, 2,2-bis(3-aminophenyl) propane, 4,4'-bis(4-aminophenoxy) biphenyl, 2,2-bis[4-(4-aminophenoxy) phenyl] propane, 2,2-bis[4-(3-aminophenoxy) phenyl] propane, 2,2-bis[4-(4-aminophenoxy) phenyl] methane, 2,2-bis[4-(3-aminophenoxy) phenyl] methane, bis[4-(4-aminophenoxy) phenyl] ether, bis[4-(3-aminophenoxy) phenyl] ether, 1,4-bis(4-aminophenoxy) benzene, 1,3-bis(4-aminophenoxy) benzene, 1,4-bis(3-aminophenoxy) benzene, 1,3-bis(3-aminophenoxy) benzene, bis[4-(4-aminophenoxy) phenyl] sulfone, bis[4-(3-aminophenoxy) phenyl] sulfone, 2,2-bis[(4-aminophenoxy) phenyl] hexafluoropropane, 2,2-bis[(3-aminophenoxy) phenyl] hexafluoropropane, 2,2-bis(4-aminophenyl) hexafluoropropane, 2,2-bis(3-aminophenyl) hexafluoropropane, and 9,9-bis(4-aminophenyl) fluorene.

The thermoplastic polyimide of the present invention comprising said tetracarboxylic dianhydride residues and diamine residues has a glass transition temperature of 250˚C or above and 260˚C or below, and does not easily suffer thermal degradation. The use of the thermoplastic polyimide of the present invention allows the polyimide film laminate to maintain adhesion under treatment at a high temperature of 360˚C or above. It is high in heat adhesiveness and can be adhered to metal foil by low-temperature thermocompression bonding in a short-time, and therefore, it is suited to continuous thermocompression bonding. The glass transition temperature should preferably be 252˚C or above and 258˚C or below. Here, the glass transition temperature is measured with a differential scanning calorimeter (DSC). In the present invention, the thermoplastic polyimide is heated to 350˚C, cooled to 100˚C, and then heated at a temperature increase rate of 20˚C/min up to 450˚C, and the glass transition temperature is determined from the inflection point in the DSC curve.

With respect to the molar ratio of the total tetracarboxylic dianhydride residues and the total diamine residues in the thermoplastic polyimide of the present invention, the molar ratio of the total tetracarboxylic dianhydride residues should preferably be 100.1 or more, more preferably 100.2 or more, for 100 of the total diamine residues, while for the upper limit, the ratio should preferably be 105 or less, more preferably 102 or less. By adjusting the molar ratio of the total tetracarboxylic dianhydride residues to 100.1 or more, a tetracarboxylic dianhydride residue will tend to be at each chain end. This serves to decrease the glass transition temperature, making it possible to produce a thermoplastic polyimide with high adhesive strength. By adjusting the molar ratio of the total tetracarboxylic dianhydride residues to 105 or less, in addition, the material will have a high molecular weight, a high tensile modulus, and a rupture elongation.

Alternatively, it is also preferred to contain additional monoamine residues. A thermoplastic polyimide with its chain end capped with monoamine will also have a low glass transition temperature, and a thermoplastic polyimide with high adhesive strength will be produced. With respect to the molar ratio of the total monoamine residues and the total diamine residues, the molar ratio of the total monoamine residues should preferably be 0.2 or more, more preferably 0.4 or more, for 100 of the total diamine residues, while for the upper limit, the ratio should preferably be 10 or less, more preferably 4 or less. With respect to the molar ratio of the total tetracarboxylic dianhydride residues and the total diamine residues, the molar ratio of the total tetracarboxylic dianhydride residues should preferably be 100.1 or more, more preferably 100.2 or more, for 100 of the total diamine residues, while for the upper limit, the ratio should preferably be 105 or less, more preferably 102 or less. By adjusting the molar ratio of the total tetracarboxylic dianhydride residues to 100.1 or more, and that of the total monoamine residues to 0.2 or more, a thermoplastic polyimide with high adhesive strength can be produced because the chain ends can be capped with monoamine. By adjusting the molar ratio of the total tetracarboxylic dianhydride residues to 105 or less, and that of monoamine to 10 or less, the thermoplastic polyimide will have a high molecular weight, a high tensile modulus, and a rupture elongation. Thus, it is possible to produce a thermoplastic polyimide that has a high tensile modulus, a high rupture elongation and a high adhesive strength simultaneously. Specifically, such monoamines include aniline, toluidine, dimethyl aniline, anisidine, aminophenol, aminocreosol, and aminothiophenol. These monoamines are used to cap the chain ends of the thermoplastic polyimide.

Alternatively, it is also preferred to contain additional dicarboxylic anhydride residues. A thermoplastic polyimide with its chain ends capped with dicarboxylic anhydride will have a low glass transition temperature, and a thermoplastic polyimide with high adhesive strength will be produced. With respect to the molar ratio of the total dicarboxylic anhydride residues and the total diamine residues, the molar ratio of the total dicarboxylic residues should preferably be 0.2 or more, more preferably 0.4 or more, for 100 of the total diamine residues, while for the upper limit, the ratio should preferably be 10 or less, more preferably 4 or less. With respect to the molar ratio of the total tetracarboxylic dianhydride residues and the total diamine residues, the molar ratio of the total tetracarboxylic dianhydride residues should preferably be 95 or more, more preferably 98 or more, for 100 of the total diamine residues, while for the upper limit, the ratio should preferably be 99.9 or less, more preferably 99.8 or less. By adjusting the ratio of the total tetracarboxylic dianhydride residues to 95 or more, and that of the total dicarboxylic anhydride residues to 10 or less, the thermoplastic polyimide will have a high molecular weight, a high tensile modulus, and a rupture elongation. By adjusting the ratio of the total tetracarboxylic dianhydride residues to 99.9 or less, and that of the total dicarboxylic anhydride residues to 0.2 or more, a thermoplastic polyimide with high adhesive strength can be produced because the chain ends can be capped with dicarboxylic anhydride. Thus, it is possible to produce a thermoplastic polyimide that has a high tensile modulus, a high rupture elongation, and a high adhesive strength, simultaneously. Specifically, such dicarboxylic anhydrides include phthalic anhydride, maleic anhydride, and 1,8-naphthalic anhydride. Dicarboxylic anhydride is used to cap the chain end of thermoplastic polyimide.

The thermoplastic polyimide of the present invention can be produced, for instance, through imidization of a polyimide precursor varnish that is obtained by reacting a tetracarboxylic dianhydride and a diamine, with a monoamine or dicarboxylic anhydride as required, in an organic solvent. Polyamic acid, i.e. the polyimide precursor, is polymerized by, for instance, allowing a diamine and a tetracarboxylic dianhydride, mixed at an appropriate ratio, to react in an appropriate solvent in the temperature range of 0 to 80°C for 0.1 to 72 hours.

Preferred organic solvents include, for instance, amide solvents such as N-methyl-2-pyrolidone, N,N-dimethyl acetamide, and N,N-dimethyl formamide; lactone solvents such as γ-butyrolactone; ether solvents such as methyl cellosolve; and ester solvents such as ethyl lactate. Hydrocarbon solvents such as toluene and xylene may be added to these.

Said polyimide precursor varnish may contain additives such as filler, releasable adjustor, dehydrator, and catalyst. Such fillers include silica, alumina, titanium oxide, quartz powder, magnesium carbonate, potassium carbonate, barium sulfate, mica, and talc. Such releasable adjustors include triphenyl phosphite and triphenyl phosphate. Such dehydrators include organic acid anhydrides such as acetic anhydride. Such catalysts include organic tertiary amines such as triethyl amine, pyridine, β-picoline, isoquinoline, and 2-methyl imidazole.

Monolayer thermoplastic polyimide film can be produced from the resulting polyimide precursor varnish. Sheets can be produced by, for instance, extruding the polyimide precursor varnish onto a support such as rotating drum and endless belt. The solvent is removed from the resulting sheet by an appropriate method such as hot air drying to provide self-supporting film, which is then released from the support. The resulting self-supporting film is heat-treated at a temperature higher than the glass transition temperature with its edges fixed by gripping.

Then, the polyimide film laminate of the present invention is described below. The polyimide film laminate of the present invention comprises a highly heat-resistant polyimide layer with a heat-adhesive polyimide layer comprising said thermoplastic polyimide provided at least on one side. Said heat-adhesive polyimide layer may be provided on only one side or on both sides of said highly heat-resistant polyimide layer.

In the present invention, a highly heat-resistant polyimide is defined as a polyimide with a glass transition temperature of 350°C or above. Polyimides comprise a pyromellitic dianhydride residue and/or 3,3',4,4'-biphenyl tetracarboxylic dianhydride residue as tetracarboxylic dianhydride residue, and at least one residue selected from the group of paraphenylene diamine residues, 2,5-diaminotoluene residues, 2-methoxy-1,4-phenylene diamine residues, 4,4'-diaminobenzanilide residues, 2'-methyl-4,4'-diaminobenzanilide residues, 2'-methoxy-4,4'-diaminobenzanilide residues, benzidine residues, 2,2'-dimethyl-4,4'-diaminobiphenyl residues, 3,3'-dimethyl-4,4'-diaminobiphenyl residues, 2,2'-dimethoxy-4,4'-diaminobiphenyl residues, 3,3'-dimethoxy-4,4'-diaminobiphenyl residues, 2,2'-ditrifluoromethyl-4,4'-diaminobiphenyl residues, 3,3'-ditrifluoromethyl-4,4'-diaminobiphenyl residues, and 4,4'-diaminodiphenyl ether residues as diamine desidue is preferably used. Said highly heat-resistant polyimide film may be a polyimide film product such as Kapton (registered trademark) (manufactured by Du Pont-Toray Co., Ltd.), Upilex (registered trademark) (manufactured by Ube Industries, Ltd.), and Apical (registered trademark) (manufactured by Kaneka Corporation).

In the present invention, a heat-adhesive polyimide is defined as a polyimide that becomes adhesive when heated at a temperature of 250°C or above and 500°C or below. Being heat-adhesive, it can be adhered to metal foil by thermocompression bonding at a temperature of 250°C or above and 500°C or below. In the polyimide film laminate of the present invention, the heat-adhesive polyimide layer should preferably contain 80 wt% or more of said thermoplastic polyimide of the present invention. Additives such as other polyimides, other resins or fillers may also be contained unless they impair the object of the present invention. Said other resins include acrylic resin, butadiene resin, urethane resin, polyester resin, polyamide resin, polyamide-imide resin, epoxy resin, and phenol resin. As additives such as fillers, those listed above as contained component for said polyimide precursor varnish can be used.

In the polyimide film laminate of the present invention, the thickness of said highly heat-resistant polyimide layer should preferably be 2μm or more, more preferably 5μm or more, and still more preferably 7μm or more, from the view point of the handling of the polyimide film laminate. It should also preferably be 50μm or less, more preferably 20μm or less. The thickness of the heat-adhesive polyimide layer should preferably be 0.2μm or more, more preferably 0.5μm or more, and still more preferably 1μm or more. It should also preferably be 50μm or less, more preferably 12μm or less, still more preferably 10μm or less, and still more preferably 7μm or less.

A thermoplastic polyimide film or polyimide film laminate produced from the thermoplastic polyimide of the present invention should preferably have a tensile modulus of 3 GPa or more and 12 GPa or less and a rupture elongation of 40%. For easy handling, the tensile modulus should more preferably be 4 GPa or more and 11 GPa or less, still more preferably 5 GPa or more and 10 GPa or less. A polyimide film in these ranges of tensile modulus can be obtained by, for instance, laminating said heat-adhesive polyimide layer of the present invention with a highly heat-resistant polyimide layer. The rupture elongation, on the other hand, should preferably be 50% or more. A polyimide film with a rupture elongation of 50% or more can be obtained by, for instance, laminating the thermoplastic polyimide layer of the present invention with a highly heat-resistant polyimide layer.

Said tensile modulus and rupture elongation can be determined by the method specified in ASTM-D882 using a tensile tester. Specifically, a Tensilon tester is used to expend a 10 mm wide,100 mm long, rectangular specimen at a tension speed of 200 mm/min, and the tensile modulus is calculated from the tensile stress-strain curve obtained (temperature 23˚C, humidity 65%RH). The tensile modulus is calculated by applying the following equation to the straight portion in the low strain region of the tensile stress-strain curve.

$$E_m = \Delta\sigma/\Delta\varepsilon$$

$E_m$: tensile modulus
$\Delta\sigma$: Difference in stress between two points on the straight portion based on the original average cross section
$\Delta\varepsilon$: Difference in strain between the same two points

The rupture elongation, on the other hand, is calculated by the following equation.

$$l = \{(L - L_0)/L\} \times 100$$

1: rupture elongation L: distance between two marked lines at rupture $L_0$: original distance between marked lines

If the polyimide film laminate comprises a heat-adhesive polyimide layer on only one side of a highly heat resistant polyimide layer, it should preferably have three or more polyimide layers containing a highly heat-resistant polyimide layer (C) with a linear thermal expansion coefficient $\alpha_C$ of $-5 \times 10^{-6}$ (1/˚C) or more and $15 \times 10^{-6}$ (1/˚C) or less at a temperature of 30˚C to 200˚C, wherein one outermost layer (A) is said heat-adhesive polyimide layer comprising the thermoplastic polyimide of the present invention while the other outermost layer (B) is a non-heat-adhesive polyimide layer with a linear thermal expansion coefficient $\alpha_B$ of more than $15 \times 10^{-6}$ (1/˚C) and $40 \times 10^{-6}$ (1/˚C) or less at 30˚C to 200˚C. A non-heat-adhesive polyimide layer provided as the outermost layer on the opposite side to the heat-adhesive polyimide layer makes it possible to perform thermocompression bonding with metal foil while avoiding thermocompression with protective film or heating rollers. For the present invention, a non-heat-adhesive polyimide is defined as a polyimide that is not heat-adhesive when heated at a temperature of 250˚C or above and 500˚C or below.

The linear thermal expansion coefficient of a polyimide layer used for the present invention should be determined by measuring the sample length under a load of 4.9 mN at different temperatures in thermomechanical analysis equipment. Here, a polyimide film sample with a length of 15 mm was rolled to form a tube, which was then annealed at an elevated temperature of 220˚C, cooled to 30˚C or below, and subsequently heated at a rate of 5˚C/min up to 200˚C, followed by calculation of the average linear thermal expansion coefficient in the range of 30˚C to 200˚C. The equation used for the calculation is described below.

$$\text{Linear thermal expansion coefficient } \alpha = (1/L_{30}) \times [(L_{200}-L_{30})/(200-30)],$$

where $L_{30}$ and $L_{200}$ represent the sample length at 30˚C and 200˚C, respectively.

It is also preferred that the difference between the linear thermal expansion coefficient $\alpha_A$ of the layer (A) at 30˚C to 200˚C and the linear thermal expansion coefficient $\alpha_B$ of the layer (B) at 30˚C to 200˚C is $5 \times 10^{-6}$ (1/˚C) or less. By adjusting the difference in linear thermal expansion coefficient at 30˚C to 200˚C between the layer (A) and the layer (B) to $5 \times 10^{-6}$ (1/˚C) or less, the shrinkage of the two surface layers caused by changes in temperature can be controlled at the same level to prevent them from suffering significant warp. The difference should preferably be $3 \times 10^{-6}$ (1/˚C) or less, more preferably $2 \times 10^{-6}$ (1/˚C) or less

For the polyimide film laminate of the present invention, the linear thermal expansion coefficient $\alpha_A$ of the heat-adhesive polyimide layer (A) at 30˚C to 200˚C should preferably be $40 \times 10^{-6}$ (1/˚C) or less. It should more preferably be $38 \times 10^{-6}$ (1/˚C) or less. It also should preferably be $30 \times 10^{-6}$ (1/˚C) or more. By adjusting the linear expansion coefficient of the layer (A) to $40 \times 10^{-6}$ (1/˚C) or less, it will be easy to control the difference in linear thermal expansion coefficient between the layer (A) and the layer (B) at $5 \times 10^{-6}$ (1/˚C) or less.

The layer (A) comprises the thermoplastic polyimide of the present invention, and the thermoplastic polyimide of the present invention preferably accounts for 80 wt% or more of the layer (A). It may contain other polyimide materials, other resins or additives including releasable adjustors, dehydrators, catalysts, and fillers unless they impair the object of the present invention. Such other resins include acrylic resin, butadiene resin, urethane resin, polyester resin, polyamide resin, polyamide-imide resin, epoxy resin, and phenol resin. Such releasable adjustors, dehydrators, catalysts, and fillers include those listed above as additives contained for said polyimide precursors.

The use of a non-heat-adhesive material as the layer (B) makes it possible to prevent said polyimide film laminate from being heat-adhered to heating rollers or protective film while undergoing thermocompression bonding with metal foil. Polyimides with a large linear expansion coefficient are generally soft and heat-adhesive, and therefore, the linear expansion coefficient $\alpha_B$ of the non-heat-adhesive polyimide layer (B) at 30˚C to 200˚C is normally $40 \times 10^{-6}$ (1/˚C) or less, and should preferably be $38 \times 10^{-6}$ (1/˚C) or less. It also should preferably be more than $15 \times 10^{-6}$ (1/˚C), more preferably $30 \times 10^{-6}$ (1/˚C) or more.

The layer (B) should preferably comprises a polyimide material wherein pyromellitic dianhydride residues account for 80 mol% or more of the total tetracarboxylic dianhydride residues, 4,4'-diaminodiphenyl ether residues for 40 mol% or more and 100 mol% or less of the total diamine residues, and paraphenylene diamine residues for 0 mol% or more and 60 mol% or less of the total diamine residues. The use of a polyimide material with such a composition serves to adjust the linear thermal expansion coefficient $\alpha_B$ at 30˚C to 200˚C to $40 \times 10^{-6}$ (1/˚C) or less and maintain the difference between the linear thermal expansion coefficient $\alpha_B$ of the layer (B) and the linear thermal expansion coefficient $\alpha_A$ of the layer (A) at $5 \times 10^{-6}$ (1/˚C) or less. Thus, a low-warp polyimide film laminate can be easily produced.

Said polyimide with the above-mentioned composition should preferably account for 80 wt% or more of the layer (B). It may contain other polyimide materials, other resins or additives including releasable adjustors, dehydrators, catalysts, and fillers unless they impair the object of the present invention. Such other resins, additives such as releasable adjustors, dehydrators, catalysts, and fillers include those listed above for the layer (A).

In the present invention, the warp of said polyimide film laminate is determined by cutting out a 100 mm $\times$ 100 mm specimen from said polyimide film laminate and leaving it on a flat metal plate for 24 hours under the conditions of 25˚C and 40 to 60%RH, and measuring the total of the heights of the four corners that have risen up. The warp should preferably be 10 mm or less, more preferably 4 mm or less.

The linear thermal expansion coefficient $\alpha_C$ of the highly heat-resistant polyimide layer (C) at 30˚C to 200˚C should be $-5 \times 10^{-6}$ (1/˚C) or more and $15 \times 10^{-6}$ (1/˚C) or less. The layer (C) with a linear thermal expansion coefficient in this range serves to allow the linear thermal expansion coefficient of the entire polyimide film laminate to be easily adjusted in the range of $10 \times 10^{-6}$ (1/˚C) or more and $25 \times 10^{-6}$ (1/˚C) or less. This acts to reduce the difference in linear thermal expansion coefficient from metal foil, copper foil in particular, allowing the resulting metal foil clad polyimide film laminate to have a reduced warp. To obtain such a polyimide layer (C), it is preferred to use a polyimide material wherein at least either pyromellitic dianhydride residues or 3,3',4,4'-biphenyl tetracarboxylic dianhydride residues account for 50 mol% or more of the total tetracarboxylic dianhydride residues while at least one of the group of paraphenylene diamine, 2,5-diaminotoluene, 2-methoxy-1,4-phenylene diamine, 4,4'-diaminobenzanilide, 2'-methyl-4,4'-diaminobenzanilide, 2'-methoxy-4,4'-diaminobenzanilide, benzidine, 2,2'-dimethyl-4,4'-diaminobiphenyl, 3,3'-dimethyl-4,4'-diaminobiphenyl, 2,2'-dimethoxy-4,4'-diaminobiphenyl, 3,3'-dimethoxy-4,4'-diaminobiphenyl, 2,2'-ditrifluoromethyl-4,4'-diaminobiphenyl, and 3,3'-ditrifluoromethyl-4,4'-diaminobiphenyl accounts for 50 mol% or more of the total diamine residues.

Said polyimide material with the above-mentioned composition should preferably account for 80 wt% or more of the layer (C). It may contain other polyimide materials, other resins or additives including releasable adjustors, dehydrators, catalysts, and fillers unless they impair the object of the present invention. Such other resins, additives such as releasable adjustors, dehydrators, catalysts, and fillers include those listed above for the layer (A).

Polyimide materials used as said layer (A), layer (B) and layer (C) can be obtained by the same process as for said thermoplastic polyimide. A monolayer polyimide film can also be produced by the same process as for said thermoplastic polyimide.

In the case where the polyimide film laminate of the present invention comprises a non-heat-adhesive polyimide layer (B), the thickness of said layer (B) should preferably be 0.2μm or more, more preferably 0.5μm or more, and still more preferably 1μm or more, and also should preferably be 12μm or less, more preferably 10μm or less, and still more preferably 7μm or less. The ratio of the thickness of the layer (A) to that of the layer (B) should preferably be in the range from 2/1 to 1/2 in order to reduce the warp of the polyimide film laminate.

Next, the production process for the polyimide film laminate of the present invention is described below.

A polyimide film laminate can be obtained by, for instance, applying polyimide precursor varnish that constitutes the heat-adhesive polyimide layer to a highly heat-resistant polyimide film with a glass transition temperature of 350˚C or above such as Kapton (registered trademark) (manufactured by Du Pont-Toray Co., Ltd.), Upilex (registered trademark) (manufactured by Ube·Industries, Ltd.) and Apical (registered trademark) (manufactured by Kaneka Corporation). Specifically, polyimide precursor varnish may be applied to the highly heat-resistant polyimide film with a bar coater, roll coater, comma coater, dye coater, gravure coater, or knife coater, followed by removing the solvent by hot air drying etc., and performing heat treatment at a temperature equal to or higher than the glass transition temperature of the thermoplastic polyimide. This process serves to produce a heat-adhesive polyimide layer on one side or on both sides of the highly heat-resistant polyimide film.

A polyimide film laminate can be obtained by forming a heat-adhesive polyimide layer on one side of the highly heat-resistant polyimide film and coating the other side with a polyimide precursor varnish that forms a non-heat-adhesive polyimide layer. To form polyimide layers on both sides, the layers may be formed simultaneously or one after the other.

It is also possible to produce a polyimide film laminate by co-extruding a polyimide precursor varnish used to form said heat-adhesive polyimide layer with a polyimide precursor varnish used to form said highly heat-resistant polyimide layer. A process that uses co-extrusion to produce a polyimide film laminate is preferred because it is free of peeling of the polyimide layers. Such processes to produce polyimide film laminates include, for instance, a polyimide film laminate production process comprising the step (1) for co-extrusion of at least a highly heat-resistant polyimide precursor solution and a thermoplastic polyimide precursor solution and the step (2) for heat treatment at a temperature of 360˚C or above. If a non-thermoplastic polyimide layer is required, a non-thermoplastic polyimide precursor solution may be co-extruded in the step (1). Specifically, separate polyimide precursor varnish flows are fed from two or three extruders through flow channels, combined into a multilayer laminate by a multi manifold die or feedblock, discharged onto a support such as endless belt and drum to produce a sheet. The solvent is removed by hot air drying etc. to produce self-supporting film, which is then peeled off from the support, and subsequently the self-supporting film is held by gripping its edges and heat-treated at a temperature of 360˚C or above. During this process, the heat treatment should preferably be performed at 360˚C or above, more preferably 380˚C or above, in order to increase the rupture elongation of the highly heat-resistant polyimide layer.

If heat-adhesive polyimide layers are to be formed on both sides of the highly heat-resistant polyimide layer, co-extrusion is carried out to produce a laminate having a structure of a heat-adhesive polyimide layer / a highly heat-resistant polyimide layer / a heat-adhesive polyimide layer. When a heat-adhesive polyimide layer is to be formed on one side and a non-heat-adhesive polyimide layer to be formed on the other side of a highly heat-resistant polyimide layer, co-extrusion is carried out to produce a laminate having a structure of a heat-adhesive polyimide layer / a highly heat-resistant polyimide layer / a non-heat-adhesive polyimide layer.

Next, the metal foil clad polyimide film laminate of the present invention is described below. The metal foil clad polyimide film laminate of the present invention comprising metal foil provided on one side or on both sides of the polyimide film laminate of the present invention.

Metal foils include aluminum foil, stainless steel foil, and copper foil. Copper foil is preferred for flexible printed circuit boards, and specifically, electrolytic copper foil or rolled copper foil is used to meet the particular objective, but either of them may be used for the present invention. The adhesion side of the copper foil may be roughened to improve the contact with the thermoplastic polyimide layer. Such roughening of copper foil may not be carried out in other cases where fine pitch is used or transparency is required. Either may be used for the present invention. Said copper foil may be rustproofed as required. In most cases, rustproofing is carried out by forming a thin film layer of a nickel, zinc, or chrome compound over the copper foil surface. Furthermore, the copper foil surface may be treated with a silane coupling agent to improve the contact with the thermoplastic polyimide layer. This thickness of the metal foil should preferably be 1$\mu$m or more and 50$\mu$m or less.

Said metal foil clad polyimide film laminate can be produced by thermocompression bonding of a polyimide film laminate and metal foil. Hot pressing or heating roller lamination may be performed to achieve thermocompression bonding, but heating roller lamination is preferred in terms of productivity.

Said heating roller lamination should preferably be carried out under the conditions of a roller temperature of 300 to 500˚C, a roller's nip pressure (linear pressure) of 0.5 to 200 N/mm, a conveyance speed of 0.1 to 50 m/min. Said lamination may be performed in a nitrogen atmosphere or vacuum to prevent oxidation of the metal foil during the lamination step. In addition, heat-resistant film, such as polyimide film, stainless steel foil or aluminum foil may be provided between the heating roller and the metal foil to serve as protective film. The resulting metal foil clad polyimide film laminate can sufficiently serve practical purposes and can be used effectively as material for flexible printed circuit boards if the adhesive strength between the metal foil and the polyimide film is 10 N/cm or more. They should more preferably be 12 N/cm or more, still more preferably 13 N/cm or more.

If the heat resistance polyimide layer has metal foil only on one side, and is provided with a non-heat-adhesive polyimide layer on the other side that is free from thermally compressed metal foil, it can be easily peeled off because it does not come in contact with the heating roller, intervening heat-resistant film, or metal foil. It will also be possible to obtain low-warp metal foil clad polyimide film laminate.

The warp of a metal foil clad polyimide film laminate or a polyimide film laminate comprising said metal foil clad polyimide film laminate with entirely etched metal foil can be measured by the same methods as for polyimide film laminates. In any case, the warp should preferably be 10 mm or less, more preferably 4 mm or less.

Examples

The present invention is illustrated below by referring to examples, but they are not intended to place any limits on the invention. The evaluation methods for the glass transition temperature, adhesive strength, tensile modulus and rupture elongation are described below.

(1) glass transition temperature

A standard aluminum container was filled with about 5 mg of polyimide film, and the glass transition temperature was measured by differential scanning calorimetry (DSC). A DSC-50 differential scanning calorimeter (manufactured by Shimadzu Corporation) was used for the measurement. The specimen was heated up to 350°C, cooled down to 100°C, and heated again at a heating rate of 20°C/min up to 450°C, and the glass transition temperature was determined from the inflection point in the resulting DSC curve.

(2) adhesive strength

The metal foil of the metal foil clad polyimide film laminate was etched with a ferric chloride solution to produce a pattern with a width of 2 mm. To determine the adhesive strength, this 2 mm wide metal layer was peeled by pulling in a Tensilon UTM-4-100 machine (manufactured by Toyo Boldwin) in the 90° direction at a pulling rate 50 mm/min.

(3) tensile modulus, rupture elongation

Measurements were made with a tensile tester according to a procedure specified in ASTM-D882 under the conditions given below.
Measuring apparatus: Tensilon AMF/RTA-100 manufactured by Orientec Co., Ltd.
Sample size: 10 mm (width) $\times$ 100mm (test length)
Pulling rate: 200 mm/min
Measuring environment: temperature 23°C, humidity 65%RH
The tensile modulus was calculated from the straight portion in the low strain region of the tensile stress-strain curve.

$$E_m = \Delta\sigma/\Delta\varepsilon$$

$E_m$: tensile modulus
$\Delta\sigma$: Difference in stress between two points on the straight portion based on the original average cross section
$\Delta\varepsilon$: Difference in strain between the same two points
The rupture elongation was calculated by the following equation.

$$l = \{(L - L_0)/L\} \times 100$$

1: rupture elongation
L: distance between two marked lines at rupture
$L_0$: original distance between marked lines

(4) linear thermal expansion coefficient

A polyimide film sample with a size of 30 mm $\times$ 15 mm was cut out and rolled in the length direction to form a tube-like sample. A load of 4.9 mN was applied to the sample in a SS-6100 thermomechanical analysis equipment (manufactured by Seiko Instruments Inc.) and the sample length was measured at different temperatures. The sample was annealed at an elevated temperature of 220°C, cooled to 30°C or below, and subsequently heated at a rate of 5°C/min from 30°C up to 200°C, followed by calculation of the average linear thermal expansion coefficient in the range of 30°C to 200°C. The equation used for the calculation is described below

$$\text{Linear thermal expansion coefficient } \alpha = (1/L_{30}) \times [(L_{200} - L_{30})/(200-30)],$$

where $L_{30}$ and $L_{200}$ represent the sample length at 30˚C and 200˚C, respectively.

(5) warp

A polyimide film laminate sample of 100 mm $\times$ 100 mm was cut out, left to stand for 24 hours under the conditions of 25˚C and 40 to 60%RH, and placed carefully on a flat metal plate, and the heights of the four corners that have warped up. The total of the heights was taken as the warp of the polyimide film laminate (warp 1). For a metal foil clad polyimide film laminate with thermally compressed metal foil on only one side, a similar sample of 100 mm $\times$ 100 mm was cut out, left to stand for 24 hours under the conditions of 25˚C and 40 to 60%RH, and placed carefully on a flat metal plate, and the heights of the four corners that have warped up. The total of the heights was taken as the warp of the metal foil clad polyimide film laminate (warp 2). In addition, the entire surface of the copper foil of the metal foil clad polyimide film laminate was etched with a ferric chloride solution. Then a similar sample of 100 mm $\times$ 100 mm was cut out, left to stand for 24 hours under the conditions of 25˚C and 40 to 60%RH, and placed carefully on a flat metal plate, and the heights of the four corners that have warped up. The total of the heights was taken as the warp of the copper-etched laminate (warp 3). The measured warp is defined as positive (+) if the layer (A) side of the polyimide film laminate or the copper foil side of the metal foil clad polyimide film laminate is the inner side of the warped laminate while it is negative (-) if the laminate is warped in the opposite direction.

In the production examples given below, the substances used, including tetracarboxylic dianhydride, diamine, monoamine, dicarboxylic anhydride, and solvent, are represented by the following abbreviations. The compositions of the polyamic acids produced are listed in Table 1.

sBPDA: 3,3',4,4'-biphenyl tetracarboxylic dianhydride
aBPDA: 2,3,3',4'-biphenyl tetracarboxylic dianhydride
PMDA: pyromellitic dianhydride
BTDA: 3,3',4,4'-benzophenone tetracarboxylic dianhydride
ODPA: 3,3',4,4'-oxydiphthalic dianhydride
DAE: 4,4'-diaminodiphenyl ether
PDA: paraphenylene diamine
TPE-R: 1,3-bis(4-aminophenoxy) benzene
BAPS: bis[4-(4-aminophenoxy) phenyl] sulfone
m-TB: 2,2'-dimethyl-4,4'-diaminobiphenyl
SiDA: 1,1,3,3-tetramethyl-1,3-bis(3-aminomethyl) disiloxane
PA: phthalic anhydride
AN: aniline
NMP: N-methyl-2-pyrolidone

Production example 1

First, 2.70kg of PDA, 15.02kg of DAE, and 120kg of NMP were fed to a reaction vessel provided with a thermometer, drying nitrogen inlet, heater/cooler using hot and cool water, and stirrer, and stirred at 30˚C to achieve complete dissolution. Then, 29.72kg of sBPDA and 69.75kg of NMP were fed at 30˚C. They were allowed to react at 60˚C for 4 hours to produce 20 wt% polyamic acid varnish 1 (PAA1). This was imidized to provide thermoplastic polyimide, which had a glass transition temperature of 253˚C and a linear thermal expansion coefficient of 34 $\times$ 10$^{-6}$ (1/˚C) in the range of 30˚C to 200˚C.

Production example 2

First, 2.70kg of PDA, 15.02kg of DAE, and 120kg of NMP were fed to a reaction vessel provided with a thermometer, drying nitrogen inlet, heater/cooler using hot and cool water, and stirrer, and stirred at 30˚C to achieve complete dissolution. Then, 29.13kg of sBPDA and 60kg of NMP were fed at 30˚C. They were allowed to react at 60˚C for 4 hours, and cooled to 30˚C, followed by adding 0.30kg of PA and 8.60kg of NMP and allowing them to react at 60˚C for 2 hours to produce 20 wt% polyamic acid varnish 2 (PAA2). This was imidized to provide thermoplastic polyimide, which had a glass transition temperature of 253˚C and a linear thermal expansion coefficient of 34 $\times$ 10$^{-6}$ (1/˚C) in the range of 30˚C to 200˚C.

Production example 3

First, 2.70kg of PDA, 15.02kg of DAE, and 120kg of NMP were fed to a reaction vessel provided with a thermometer, drying nitrogen inlet, heater/cooler using hot and cool water, and stirrer, and stirred at 30˚C to achieve complete dissolution. Then, 29.72kg of sBPDA and 60kg of NMP were fed at 30˚C. They were allowed to react at 60˚C for 4 hours, and cooled to 30˚C, followed by adding 0.19kg of AN and 10.50kg of NMP and allowing them to react at 60˚C for 2 hours to produce 20 wt% polyamic acid varnish 3 (PAA3). This was imidized to provide thermoplastic polyimide, which had a glass transition temperature of 253˚C and a linear thermal expansion coefficient of $34 \times 10^{-6}$ (1/˚C) in the range of 30˚C to 200˚C.

Production examples 4 to 26

The diamine and tetracarboxylic dianhydride materials given in Tables 1 and 2 are fed as in Example 1 to produce polyamic acid varnishes 4 to 26 (PAA4 to PAA26). They were imidized to provide polyimides. Their glass transition temperatures and linear thermal expansion coefficients in the range of 30˚C to 200˚C are shown in Tables 1 and 2.
[Table 1]
[Table 2]

Example 1

PAA1 and PAA16 were adjusted to have a viscosity of 300Pa·s, discharged from extruders respectively, extruded by a feedblock onto an endless belt to produce a three layered polyamic acid sheet having the structure of PAA1 (30μm) / PAA16 (90μm) / PAA1 (30μm). This was dried in hot air to produce a self-supporting film, which was removed from the endless belt, and heated gradually from 200˚C to 400˚C with both ends gripped with pins, and then the solvent was removed, followed by imidization to produce a polyimide film laminate. The resulting polyimide film consisted of a 9μm thick highly heat-resistant polyimide layer sandwiched between two 3μm thick thermoplastic polyimide layers, and had a total thickness of 15μm. The resulting polyimide film laminate had a tensile modulus of 5.1 Gpa and a rupture elongation of 60%.
A 12μm thick rolled copper foil (BHY; manufactured by Nikko Materials Co., Ltd.) was thermocompression-bonded continuously to both sides of the resulting polyimide film laminate using a heated roller laminator under the conditions of a roller temperature of 350˚C, roller's nip pressure of 50 N/mm, and conveyance speed of 2 m/min to provide a metal foil clad polyimide film laminate. In this process, a Kapton 500H polyimide film (manufactured by Du Pont-Toray Co., Ltd.) was provided between the copper foil and the heating roller. The adhesive strength between the copper foil and the polyimide film laminate was 15 N/cm.

Examples 2 to 10

The same procedure as in Example 1 was carried out except that PAAs 2 to 6, 12, 14, 23, and 25 were used instead of PAA1, in order to produce polyimide film laminates. The tensile modulus and rupture elongation of the resulting polyimide film laminates are shown in Table 3. A metal foil clad polyimide film laminate was also produced by the same procedure as in Example 1. The adhesive strength between the copper foil and the polyimide film laminate is also given in Table 3.

Comparative examples 1 to 8

The same procedure as in Example 1 was carried out except that PAAs 7 to 11, 13, 15, and 24 were used instead of PAA1, in order to produce polyimide film laminates. The tensile modulus and rupture elongation of the resulting polyimide film laminates are shown in Table 3. A metal foil clad polyimide film laminate was also produced by the same procedure as in Example 1. The adhesive strength between the copper foil and the polyimide film laminate is also given in Table 3.

Example 11

Only PAA1 was discharged from the extruder onto the endless belt to produce a 150μm thick sheet of the polyamic acid varnish 1. This was dried in hot air to produce a self-supporting film, which was then removed from the endless belt, and heated gradually from 200˚C to 300˚C with both ends gripped with pins, and then the solvent was removed, followed by imidization to produce a thermoplastic polyimide film. The resulting thermoplastic polyimide film had a thickness of 15μm. The resulting polyimide film had a tensile modulus of 3.1 Gpa and a rupture elongation of 80%.

A 12μm thick rolled copper foil (BHY; manufactured by Nikko Materials Co., Ltd.) was thermocompression-bonded continuously to both sides of the resulting thermoplastic polyimide film using a heated roller laminator under the conditions of a roller temperature of 350˚C, roller's nip pressure of 50 N/mm, and conveyance speed of 2 m/min to provide a metal foil clad polyimide film laminate. In this process, a Kapton 500H polyimide film (manufactured by Du Pont-Toray Co., Ltd.) was provided between the copper foil and the heating roller. The adhesive strength between the copper foil and the thermoplastic polyimide film was 15 N/cm.

Example 12

PAA1 was adjusted to have a viscosity of 1 Pa·s, and applied to a Kapton 50EN polyimide film with a gravure coater. The film was heated gradually from 160˚C to 300˚C to remove the
solvent and imidize the product, producing a polyimide film with a 3μm thick thermoplastic polyimide layer laminated on one side. Then, PAA1 was applied by the same method to the opposite side to provide a polyimide film laminate having a 3μm thick thermoplastic polyimide layer laminated on both sides. The resulting polyimide film laminate had a tensile modulus of 5.1 Gpa and a rupture elongation of 50%.

A 12μm thick rolled copper foil (BHY; manufactured by Nikko Materials Co., Ltd.) was thermocompression-bonded continuously to both sides of the resulting polyimide film laminate using a heated roller laminator under the conditions of a roller temperature of 350˚C, roller's nip pressure of 50 N/mm, and conveyance speed of 2 m/min to provide a metal foil clad polyimide film laminate. In this process, a Kapton 500H polyimide film (manufactured by Du Pont-Toray Co., Ltd.) was provided between the copper foil and the heating roller. The adhesive strength between the copper foil and the polyimide film laminate was 10 N/cm, and the heat-resistant polyimide film was found to have peeled off from the thermoplastic polyimide layer.

Comparative example 9

PAA11 and PAA16 were adjusted to have a viscosity of 300Pa·s, discharged from extruders respectively, extruded by a feedblock onto an endless belt to produce a three layered polyamic acid sheet having the structure of PAA11 (30μm) / polyPAA16 (90μm) / PAA11 (30μm). This was dried in hot air to produce a self-supporting film, which was removed from the endless belt, and heated gradually from 200˚C to 320˚C with both ends gripped with pins, and then the solvent was removed, followed by imidization to produce a polyimide film laminate. The resulting polyimide film laminate consisted of a 9μm thick highly heat-resistant polyimide layer sandwiched between two 3μm thick thermoplastic polyimide layers, and had a total thickness of 15μm. The resulting polyimide film laminate had a tensile modulus of 4.5 Gpa and a rupture elongation of 20%.

A 12μm thick rolled copper foil (BHY; manufactured by Nikko Materials Co., Ltd.) was thermocompression-bonded continuously to both sides of the resulting polyimide film laminate using a heated roller laminator under the conditions of a roller temperature of 350˚C, roller's nip pressure of 50 N/mm, and conveyance speed of 2 m/min to provide a metal foil clad polyimide film laminate. In this process, a Kapton 500H polyimide film (manufactured by Du Pont-Toray Co., Ltd.) was provided between the copper foil and the heating roller. The adhesive strength between the copper foil and the polyimide film laminate was 15 N/cm.

[Table 3]

Example 13

PAA1 (layer (A)), PAA21 (layer (C)), and PAA20 (layer (B)) were adjusted to have a viscosity of 300Pa·s, discharged from extruders respectively, extruded by a feedblock onto an endless belt to produce a three layered polyamic acid sheet having the structure of PAA1 (30μm) / PAA21 (90μm) / PAA20 (30μm). This was dried in hot air to produce a self-supporting film, which was removed from the endless belt, and heated gradually from 200˚C to 400˚C with both ends gripped with pins, and then the solvent was removed, followed by imidization to produce a polyimide film laminate. The resulting polyimide film laminate consisted of a 3μm thick heat-adhesive polyimide layer (A), a 9μm thick highly heat-resistant polyimide layer (C), and a 3μm thick non-thermal-adhesive polyimide layer (B), and had a total thickness of 15μm. The polyimide film laminate had a warp (warp 1) was 0 mm.

A 12μm thick rolled copper foil (BHY; manufactured by Nikko Materials Co., Ltd.) was thermocompression-bonded continuously to the heat-adhesive polyimide layer (A) side of the resulting polyimide film laminate using a heated roller laminator under the conditions of a roller temperature of 350˚C, roller's nip pressure of 50 N/mm, and conveyance speed of 2 m/min to provide a metal foil clad polyimide film laminate. In this process, a Kapton 500H polyimide film (manufactured by Du Pont-Toray Co., Ltd.) was provided as protective film between the copper foil and the heating roller, and between the non-thermal-adhesive polyimide layer (B) side of the polyimide film laminate and the heating roller. The adhesive strength between the copper foil and the polyimide film laminate was 15 N/cm. The warp (warp 2) of the metal foil clad polyimide film laminate was 2 mm, and after etching of the metal foil, the warp (warp 3) was 1 mm.

Examples 14 to 17

The same procedure as in Example 13 was carried out except that PAAs 5, 6, 3, and 2 were used in the layer (A) instead of PAA1, in order to produce a polyimide film laminate. The warp (warp 1) of the resulting polyimide film laminate is shown in Table 4. A metal foil clad polyimide film laminate was also produced by the same procedures as in Example 13. The adhesive strength between the copper foil and the polyimide film laminate is shown in Table 4 along with the warp (warp 2) and the warp (warp 3) determined after etching of the copper foil.

Examples 18 to 20

The same procedure as in Example 13 was carried out except that PAAs 16, 22, and 26 were used in the layer (C) instead of PAA21, in order to produce a polyimide film laminate. The warp (warp 1) of the resulting polyimide film laminate is shown in Table 4. A metal foil clad polyimide film laminate was also produced by the same procedures as in Example 13. The adhesive strength between the copper foil and the polyimide film laminate, are shown in Table 4 along with the warp (warp 2) and the warp (warp 3) determined after etching of the copper foil.

Comparative example 10 to 16

The same procedure as in Example 13 was carried out except that PAAs 11, 17, 18, and 7 to 10 were used in the layer (A) instead of PAA1, in order to produce a polyimide film laminate. The warp (warp 1) of the resulting polyimide film laminate is shown in Table 4. A metal foil clad polyimide film laminate was also produced by the same procedures as in Example 13. The adhesive strength between the copper foil and the polyimide film laminate, are shown in Table 4 along with the warp (warp 2) and the warp (warp 3) determined after etching of the copper foil.

Comparative example 17

The same procedure as in Example 13 was carried out except that PAA17 was used in the layer (A) instead of PAA1 and that PAA19 was used in the layer (B) instead of PAA20, in order to produce a polyimide film laminate. However, the non-heat-adhesive polyimide layer was found to have undergone thermal adhesion with the protective film, and the layer was difficult to remove from the protective film. The warp (warp 1) of the resulting polyimide film laminate is shown in Table 4. A metal foil clad polyimide film laminate was also produced by the same procedures as in Example 13. The adhesive strength between the copper foil and the polyimide film laminate is shown in Table 4 along with the warp (warp 2) and the warp (warp 3) determined after etching of the copper foil.

Example 21

PAA1 (layer (A)) was adjusted to have a viscosity of 1 Pa·s, and applied to a Kapton 50EN polyimide film with a gravure coater. The film was heated gradually from 160˚C to 300˚C to remove the solvent and imidize the product, producing a polyimide film laminate with a 3μm thick heat-adhesive polyimide layer laminated on one side. Then, PAA20 (layer (B)) was applied by the same method to the opposite side. The resulting polyimide film laminate consisted of a 3μm thick heat-adhesive polyimide layer (layer (A)), a 12.5μm thick Kapton EN layer (layer (C)), and a 3μm thick non-heat-adhesive polyimide layer (layer (B)), and the total thickness was 18.5μm. The warp (warp 1) of the resulting polyimide film is shown in Table 4. A metal foil clad polyimide film laminate was also produced by the same procedure as in Example 13. The adhesive strength between the copper foil and the polyimide film laminate is shown in Table 4 along with the warp (warp 2) and the warp (warp 3) determined after etching of the copper foil.

[Table 4]

Industrial applicability

The present invention makes it possible to obtain a thermoplastic polyimide that is resistant to thermal degradation and low in glass transition temperature and can be adhered to metal foil by short-time thermocompression bonding. Polyimide film laminates produced from the thermoplastic polyimide of the present invention can be heat-treated at a high temperature of 360˚C or above and therefore has a high rupture elongation, and therefore, they serve effectively as material for flexible printed circuit boards used in electronic apparatus.

Table 1

| varnish | | sBPDA | aBPDA | PMDA | BTDA | ODPA | DAE | PDA | TPE-R | BAPS | m-TB | SiDA | PA | AN | NMP | glass transition temperature (˚C) | linear thermal expansion coefficient (x10$^{-6}$ (1/˚C)) |
|---|---|---|---|---|---|---|---|---|---|---|---|---|---|---|---|---|---|
| PAA1 | molar ratio (%) | 101 | | | | | 75 | 25 | | | | | | | | 253 | 34 |
| | feed amount (kg) | 29.72 | | | | | 15.02 | 2.70 | | | | | | | 189.75 | | |
| PAA2 | molar ratio (%) | 99 | | | | | 75 | 25 | | | | | 2 | | | 253 | 34 |
| | feed amount (kg) | 29.13 | | | | | 15.02 | 2.70 | | | | | 0.30 | | 188.60 | | |
| PAA3 | molar ratio (%) | 101 | | | | | 75 | 25 | | | | | | 2 | | 253 | 34 |
| | feed amount (kg) | 29.72 | | | | | 15.02 | 2.70 | | | | | | 0.19 | 190.50 | | |
| PAA4 | molar ratio (%) | 99 | | | | | 75 | 25 | | | | | | | | 260 | 34 |
| | feed amount (kg) | 29.13 | | | | | 15.02 | 2.70 | | | | | | | 188.58 | | |

EP 2 039 715 A1

| varnish | | sBPDA | aBPDA | PMDA | BTDA | ODPA | DAE | PDA | TPE-R | BAPS | m-TB | SiDA | PA | AN | NMP | glass transition temperature (°C) | linear thermal expansion coefficient (x10$^{-6}$ (1/°C)) |
|---|---|---|---|---|---|---|---|---|---|---|---|---|---|---|---|---|---|
| PAA5 | molar ratio (%) | 101 | | | | | 83 | 17 | | | | | | | | 258 | 35 |
| | feed amount (kg) | 29.72 | | | | | 16.62 | 1.84 | | | | | | | 192.70 | | |
| PAA6 | molar ratio (%) | 101 | | | | | 68 | 32 | | | | | | | | 258 | 33 |
| | feed amount (kg) | 29.72 | | | | | 13.62 | 3.46 | | | | | | | 187.17 | | |
| PAA7 | molar ratio (%) | 101 | | | | | 88 | 12 | | | | | | | | 263 | 41 |
| | feed amount (kg) | 29.72 | | | | | 17.62 | 1.30 | | | | | | | 194.54 | | |
| PAA8 | molar ratio (%) | 101 | | | | | 63 | 37 | | | | | | | | 263 | 29 |
| | feed amount (kg) | 29.72 | | | | | 12.62 | 4.00 | | | | | | | 181.00 | | |

| varnish | | sBPDA | aBPDA | PMDA | BTDA | ODPA | DAE | PDA | TPE-R | BAPS | m-TB | SiDA | PA | AN | NMP | glass transition temperature (°C) | linear thermal expansion coefficient (x10$^{-6}$ (1/°C)) |
|---|---|---|---|---|---|---|---|---|---|---|---|---|---|---|---|---|---|
| PAA9 | molar ratio (%) | 101 | | | | | 100 | | | | | | | | | 280 | 41 |
| | feed amount (kg) | 29.72 | | | | | 20.02 | | | | | | | | 198.96 | | |
| PAA 10 | molar ratio (%) | 101 | | | | | 50 | 50 | | | | | | | | 275 | 29 |
| | feed amount (kg) | 29.72 | | | | | 10.01 | 5.41 | | | | | | | 180.56 | | |
| PAA11 | molar ratio (%) | | 101 | | | | | | 100 | | | | | | | 240 | 46 |
| | feed amount (kg) | | 29.72 | | | | | | 29.23 | | | | | | 235.80 | | |
| PAA12 | molar ratio (%) | 91 | | 10 | | | 75 | 25 | | | | | | | | 259 | 35 |
| | feed amount (kg) | 26.77 | | 2.18 | | | 15.02 | 2.70 | | | | | | | 186.71 | | |

(continued)

| varnish | | sBPDA | aBPDA | PMDA | BTDA | ODPA | DAE | PDA | TPE-R | BAPS | m-TB | SiDA | PA | AN | NMP | glass transition temperature (°C) | linear thermal expansion coefficient (x10^{-6} (1/°C)) |
|---|---|---|---|---|---|---|---|---|---|---|---|---|---|---|---|---|---|
| PAA13 | molar ratio (%) | 76 | | 25 | | | 75 | 25 | | | | | | | | 262 | 35 |
| | feed amount (kg) | 22.36 | | 5.45 | | | 15.02 | 2.70 | | | | | | | 182.14 | | |
| PAA14 | molar ratio (%) | 101 | | | | | 70 | 20 | 10 | | | | | | | 251 | 39 |
| | feed amount (kg) | 29.72 | | | | | 14.02 | 2.16 | 2.92 | | | | | | 195.28 | | |
| PAA15 | molar ratio (%) | 101 | | | | | 60 | 10 | 30 | | | | | | | 244 | 42 |
| | feed amount (kg) | 29.72 | | | | | 12.01 | 1.08 | 8.77 | | | | | | 206.33 | | |

EP 2 039 715 A1

Table 2

| ワニス | | sBPDA | aBPDA | PMDA | BTDA | ODPA | DAE | PDA | TPE-R | BAPS | m-TB | SiDA | PA | AN | NMP | glass transition temperature (˚C) | linear thermal expansion coefficient (x10$^{-6}$ (1/˚C)) |
|---|---|---|---|---|---|---|---|---|---|---|---|---|---|---|---|---|---|
| PAA16 | molar ratio (%) | 25 | | 74.7 | | | 25 | 75 | | | | | | | | - | 10 |
| | feed amount (kg) | 7.36 | | 16.29 | | | 5.01 | 8.11 | | | | | | | 147.06 | | |
| PAA17 | molar ratio (%) | | | 100 | | | 10 | | | | | 90 | | | | 190 | 77 |
| | feed amount (kg) | | | 32.22 | | | 1.08 | | | | | 22.36 | | | 222.64 | | |
| PAA18 | molar ratio (%) | 101 | | | | | | | | 100 | | | | | | 210 | 61 |
| | feed amount (kg) | 29.72 | | | | | | | | 43.25 | | | | | 291.88 | | |
| PAA19 | molar ratio (%) | | | 100 | | | 30 | | | | | 70 | | | | 200 | 60 |
| | feed amount (kg) | | | 32.22 | | | 3.24 | | | | | 17.4 | | | 211.44 | | |

(continued)

| ワニス | | sBPDA | aBPDA | PMDA | BTDA | ODPA | DAE | PDA | TPE-R | BAPS | m-TB | SiDA | PA | AN | NMP | glass transition temperature (˚C) | linear thermal expansion coefficient (x10⁻⁶ (1/˚C)) |
|---|---|---|---|---|---|---|---|---|---|---|---|---|---|---|---|---|---|
| PAA20 | molar ratio (%) | | | 99.7 | | | 100 | | | | | | | | | | - | 35 |
| | feed amount (kg) | | | 21.75 | | | 20.02 | | | | | | | | | 167.08 | | |
| PAA21 | molar ratio (%) | 99.7 | | | | | | 100 | | | | | | | | | - | 7 |
| | feed amount (kg) | 29.33 | | | | | | 10.81 | | | | | | | | 160.56 | | |
| PAA22 | molar ratio (%) | | | 99.7 | | | | | | | | 100 | | | | | - | -2 |
| | feed amount (kg) | | | 21.75 | | | | | | | | 21.23 | | | | 171.92 | | |
| PAA23 | molar ratio (%) | 86 | | 15 | | | 75 | 25 | | | | | | | | | 260 | 32 |
| | feed amount (kg) | 25.3 | | 3.27 | | | 15.02 | 2.70 | | | | | | | | 185.16 | | |

| ワニス | | sBPDA | aBPDA | PMDA | BTDA | ODPA | DAE | PDA | TPE-R | BAPS | m-TB | SiDA | PA | AN | NMP | glass transition temperature (˚C) | linear thermal expansion coefficient (x10$^{-6}$ (1/˚C)) |
|---|---|---|---|---|---|---|---|---|---|---|---|---|---|---|---|---|---|
| PAA24 | molar ratio (%) | 76 | | | | 25 | 75 | 25 | | | | | | | | 248 | 38 |
| | feed amount (kg) | 22.36 | | | | 7.76 | 15.02 | 2.70 | | | | | | | 191.36 | | |
| PAA25 | molar ratio (%) | | 101 | | | | 75 | 25 | | | | | | | | 260 | 32 |
| | feed amount (kg) | | 29.72 | | | | 15.02 | 2.70 | | | | | | | 189.75 | | |
| PAA26 | molar ratio (%) | | | 99.7 | | | 60 | 40 | | | | | | | | - | 28 |
| | feed amount (kg) | | | 21.75 | | | 12.01 | 4.32 | | | | | | | 152.32 | | |

EP 2 039 715 A1

Table 3

| | thermoplastic polyimide | highly heat-resistant polyimide | tensile modulus (GPa) | rupture elongation (%) | adhesive strength with the copper foil (N/cm) |
|---|---|---|---|---|---|
| Example 1 | PAA1 | PAA16 | 5.1 | 60 | 15 |
| Example 2 | PAA2 | PAA16 | 5.1 | 60 | 15 |
| Example 3 | PAA3 | PAA16 | 5.1 | 60 | 15 |
| Example 4 | PAA4 | PAA16 | 5.1 | 60 | 10 |
| Example 5 | PAA5 | PAA16 | 5.2 | 60 | 15 |
| Example 6 | PAA6 | PAA16 | 5.0 | 70 | 15 |
| Example 7 | PAA12 | PAA16 | 5.2 | 50 | 12 |
| Example 8 | PAA14 | PAA16 | 5.0 | 60 | 11 |
| Example 9 | PAA23 | PAA16 | 5.1 | 50 | 10 |
| Example 10 | PAA25 | PAA16 | 5.1 | 60 | 10 |
| Example 11 | PAA1 | - | 3.1 | 80 | 15 |
| Example 12 | PAA1 | "Kapton"EN | 5.1 | 50 | 10 |
| Comparative example 1 | PAA7 | PAA16 | 5.2 | 60 | 3 |
| Comparative example 2 | PAA8 | PAA16 | 5.0 | 70 | 3 |
| Comparative example 3 | PAA9 | PAA16 | 5.0 | 60 | 1 |
| Comparative example 4 | PAA10 | PAA16 | 5.0 | 60 | 1 |
| Comparative example 5 | PAA11 | PAA16 | 4.5 | 20 | 3 |
| Comparative example 6 | PAA13 | PAA16 | 5.3 | 40 | 1 |
| Comparative example 7 | PAA15 | PAA16 | 4.7 | 30 | 3 |
| Comparative example 8 | PAA24 | PAA16 | 4.3 | 30 | 7 |
| Comparative example 9 | PAA11 | PAA16 | 4.5 | 20 | 15 |

Table 4

| | layer (A) | | | layer (C) | | | layer (B) | | | difference between $\alpha_A$ and $\alpha_B$ | adhesive strength (N/cm) | warp 1 (mm) | warp 2 (mm) | warp 3 (mm) |
|---|---|---|---|---|---|---|---|---|---|---|---|---|---|---|
| | varnish | $\alpha_A$ | thickness ($\mu$m) | varnish | $\alpha_C$ | thickness ($\mu$m) | varnish | $\alpha_B$ | thickness ($\mu$m) | | | warp of the polyimide film laminate | warp of the metal foil clad polyimide film laminate | warp of the copper-etched laminate |
| Example 13 | PAA1 | 34 | 3 | PAA21 | 7 | 9 | PAA20 | 35 | 3 | 1 | 15 | 0 | 2 | 1 |
| Example 14 | PAA5 | 35 | 3 | PAA21 | 7 | 9 | PAA20 | 35 | 3 | 0 | 15 | 1 | 1 | 0 |
| Example 15 | PAA6 | 33 | 3 | PAA21 | 7 | 9 | PAA20 | 35 | 3 | 2 | 15 | 0 | 1 | 0 |
| Example 16 | PAA3 | 34 | 3 | PAA21 | 7 | 9 | PAA20 | 35 | 3 | 1 | 15 | 0 | 1 | 1 |
| Example 17 | PAA2 | 34 | 3 | PAA21 | 7 | 9 | PAA20 | 35 | 3 | 1 | 15 | 1 | 0 | 1 |
| Example 18 | PAA1 | 34 | 3 | PAA16 | 10 | 9 | PAA20 | 35 | 3 | 1 | 15 | 1 | -2 | 1 |
| Example 19 | PAA1 | 34 | 3 | PAA22 | -2 | 9 | PAA20 | 35 | 3 | 1 | 15 | -1 | 4 | 1 |
| Example 20 | PAA1 | 34 | 3 | PAA26 | 28 | 9 | PAA20 | 35 | 3 | 1 | 15 | 1 | -10 | 1 |
| Example 21 | PAA1 | 34 | 3 | "Kapton"EN | 15 | 12.5 | PAA20 | 35 | 3 | 1 | 10 | 0 | 2 | 1 |
| Comparative example 10 | PAA11 | 46 | 3 | PAA21 | 7 | 9 | PAA20 | 35 | 3 | 11 | 3 | 30 | 3 | 35 |

EP 2 039 715 A1

(continued)

| | layer (A) | | | layer (C) | | | layer (B) | | | difference between $\alpha_A$ and $\alpha_B$ | adhesive strength (N/cm) | warp 1 (mm) | warp 2 (mm) | warp 3 (mm) |
|---|---|---|---|---|---|---|---|---|---|---|---|---|---|---|
| | varnish | $\alpha_A$ | thickness ($\mu$m) | varnish | $\alpha_C$ | thickness ($\mu$m) | varnish | $\alpha_B$ | thickness ($\mu$m) | | | warp of the polyimide film laminate | warp of the metal foil clad polyimide film laminate | warp of the copper-etched laminate |
| Comparative example 11 | PAA17 | 77 | 3 | PAA21 | 7 | 9 | PAA20 | 35 | 3 | 42 | 7 | 93 | 5 | 15 |
| Comparative example 12 | PAA18 | 61 | 3 | PAA21 | 7 | 9 | PAA20 | 35 | 3 | 26 | 10 | 13 | 3 | 15 |
| Comparative example 13 | PAA7 | 41 | 3 | PAA21 | 7 | 9 | PAA20 | 35 | 3 | 6 | 3 | 12 | 4 | 11 |
| Comparative example 14 | PAA8 | 29 | 3 | PAA21 | 7 | 9 | PAA20 | 35 | 3 | 6 | 3 | -11 | 1 | -12 |
| Comparative example 15 | PAA9 | 41 | 3 | PAA21 | 7 | 9 | PAA20 | 35 | 3 | 6 | 1 | 11 | 2 | 15 |
| Comparative example 16 | PAA10 | 29 | 3 | PAA21 | 7 | 9 | PAA20 | 35 | 3 | 6 | 1 | -12 | 3 | -14 |
| Comparative example 17 | PAA17 | 77 | 3 | PAA21 | 7 | 9 | PAA19 | 60 | 3 | 17 | 7 (layer B was heat-adhesive) | 7 | 4 | 8 |

**Claims**

1. A thermoplastic polyimide comprising a tetracarboxylic dianhydride residue and a diamine residue wherein the biphenyl tetracarboxylic dianhydride residues account for 80 mol% or more of the total tetracarboxylic dianhydride residues, the 4,4'-diaminodiphenyl ether residues for 65 mol% or more and 85 mol% or less of the total diamine residues, and the paraphenylene diamine residues for 15 mol% or more and 35 mol% or less of the total diamine residues.

2. A thermoplastic polyimide according to claim 1 wherein the molar ratio between the total tetracarboxylic dianhydride residues and the total diamine residues is 100.1 or more and 105 or less of the total tetracarboxylic dianhydride residues for 100 of the total diamine desidues.

3. A thermoplastic polyimide according to claim 2 wherein a monoamine residue is contained additionally, the molar ratio of the total monoamine residues being 0.2 or more and 10 or less for 100 of the total diamine residues.

4. A thermoplastic polyimide according to claim 1 wherein a dicarboxylic anhydride residue is contained additionally, the molar ratio among the total tetracarboxylic dianhydride residues, the total diamine residues, and the total dicarboxylic anhydride residues being 95 or more and 99.9 or less of the total tetracarboxylic dianhydride residues, 0.2 or more and 10 or less of the total dicarboxylic dianhydride residues, for 100 of the total diamine residues.

5. A thermoplastic polyimide according to any one of claims 1 to 4 wherein the glass transition temperature is 250˚C or above and 260˚C or below.

6. A polyimide film laminate comprising a highly heat-resistant polyimide layer with a heat-adhesive polyimide layer provided at least on one side, said heat-adhesive polyimide layer comprising a thermoplastic polyimide according to any one of claims 1 to 5.

7. A polyimide film laminate according to claim 6 comprising a three or more layered polyimide layer containing a highly heat-resistant polyimide layer (C) with a linear thermal expansion coefficient $\alpha_C$ of $-5 \times 10^{-6}$ (1/˚C) or more and $15 \times 10^{-6}$ (1/˚C) or less at 30˚C to 200˚C, wherein the outermost layer (A) on one side is a heat-adhesive polyimide layer comprising a thermoplastic polyimide according to any one of claims 1 to 5 while the outermost layer (B) on the other side is a non-heat-adhesive polyimide layer with a linear thermal expansion coefficient $\alpha_B$ of more than $15 \times 10^{-6}$ (1/˚C) and $40 \times 10^{-6}$ (1/˚C) or less at 30˚C to 200˚C.

8. A polyimide film laminate according to claim 7 wherein the difference between the linear thermal expansion coefficient $\alpha_A$ of the layer (A) at 30˚C to 200˚C and the linear thermal expansion coefficient $\alpha_B$ of the layer (B) at 30˚C to 200˚C is $5 \times 10^{-6}$ (1/˚C) or less.

9. A polyimide film laminate according to claim 7 or claim 8 wherein the linear thermal expansion coefficient $\alpha_A$ of the layer (A) at 30˚C to 200˚C is $40 \times 10^{-6}$ (1/˚C) or less.

10. A polyimide film laminate according to any one of claims 7 to 9 wherein the layer (B) is a non-heat-adhesive polyimide layer comprising polyimide comprising pyromellitic dianhydride residues that account for 80 mol% or more of the total tetracarboxylic dianhydride residues, 4,4'-diaminodiphenyl ether residues that account for 40 mol% or more and 100 mol% or less of the total diamine residues and paraphenylene diamine residues that account for 0 mol% or more and 60 mol% or less of the total diamine residues.

11. A production method for a polyimide film laminate according to any one of claims 6 to 10 comprising the step (1) for co-extrusion of at least a highly heat-resistant polyimide precursor solution and a thermoplastic polyimide precursor solution, and the step (2) for heat treatment at a temperature of 360˚C or above.

12. A metal foil clad polyimide film laminate comprising a polyimide film laminate according to any one of claims 6 to 10 having metal foil at least on one side.

**EP 2 039 715 A1**

| | | |
|---|---|---|
| **INTERNATIONAL SEARCH REPORT** | International application No.<br>PCT/JP2007/063072 | |

A.  CLASSIFICATION OF SUBJECT MATTER
*C08G73/10*(2006.01)i, *B32B15/088*(2006.01)i, *B32B27/34*(2006.01)i

According to International Patent Classification (IPC) or to both national classification and IPC

B.  FIELDS SEARCHED

Minimum documentation searched (classification system followed by classification symbols)
C08G73/00-73/26, B32B1/00-35/00

Documentation searched other than minimum documentation to the extent that such documents are included in the fields searched
Jitsuyo Shinan Koho        1922-1996    Jitsuyo Shinan Toroku Koho    1996-2007
Kokai Jitsuyo Shinan Koho    1971-2007    Toroku Jitsuyo Shinan Koho    1994-2007

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X<br>Y | JP 2-209757 A  (Kyocera Corp.),<br>21 August, 1990 (21.08.90),<br>Claims; page 3, lower left column, lines 17<br>to 20<br>(Family: none) | 1-6,11<br>7-10,12 |
| X | JP 62-263230 A  (Ube Industries, Ltd.),<br>16 November, 1987 (16.11.87),<br>Claims<br>(Family: none) | 1-6,11 |
| Y | JP 11-300887 A  (Ube Industries, Ltd.),<br>02 November, 1999 (02.11.99),<br>Claims; Par. Nos. [0010], [0011], [0023],<br>[0024]<br>(Family: none) | 7-10,12 |

☒  Further documents are listed in the continuation of Box C.    ☐  See patent family annex.

| | |
|---|---|
| *    Special categories of cited documents:<br>"A"    document defining the general state of the art which is not considered   to be of particular relevance<br>"E"    earlier application or patent but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| | |
|---|---|
| Date of the actual completion of the international search<br>    19 July, 2007 (19.07.07) | Date of mailing of the international search report<br>    31 July, 2007 (31.07.07) |
| Name and mailing address of the ISA/<br>    Japanese Patent Office | Authorized officer |
| Facsimile No. | Telephone No. |

Form PCT/ISA/210 (second sheet) (April 2005)

25

| | **INTERNATIONAL SEARCH REPORT** | International application No. |
|---|---|---|
| | | *PCT/JP2007/063072* |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2000-188445 A  (Sony Chemicals Corp.), 04 July, 2000 (04.07.00), Claims; Par. No. [0092] & EP 1014766 A2          & CN 1269285 A & US 6346298 B1 | 7-10,12 |
| P,A | JP 2006-299196 A  (Toyobo Co., Ltd.), 02 November, 2006 (02.11.06), Claims; Par. Nos. [0016] to [0017] (Family: none) | 1-12 |
| A | JP 9-99518 A  (Ube Industries, Ltd.), 15 April, 1997 (15.04.97), Claims & US 5741598 A          & KR 97073952 A | 1-12 |
| P,A | JP 2007-138058 A  (Du Pont-Toray Co., Ltd.), 07 June, 2007 (07.06.07), Claims (Family: none) | 1-12 |
| P,A | WO 2006/0098044 A1  (Toyobo Co., Ltd.), 21 September, 2006 (21.09.06), Claims; page 10, line 11 to page 11, line 1; page 22, lines 14 to 20 & JP 2006-291157 A      & JP 2006-291158 A & JP 2006-291164 A      & JP 2006-291165 A | 1-12 |

Form PCT/ISA/210 (continuation of second sheet) (April 2005)

| **INTERNATIONAL SEARCH REPORT** | International application No. |
|---|---|
| | PCT/JP2007/063072 |

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:
  The present international application involves the following two groups of inventions.
  1. Claims 1-6 and 11
  2. Claims 7-10 and 12
  As stated in Box C, the 1$^{st}$ group of inventions has no novelty or inventive step over JP 2-209757 A.
  Therefore, there is no technical relationship between the two groups of inventions involving one or more of the same or corresponding special technical features that make a contribution over the prior art.

1. ☐ As all required additional search fees were timely paid by the applicant, this international search report covers all searchable claims.

2. ☒ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant.    Consequently, this international search report is restricted to the invention first mentioned in the claims; it is covered by claims Nos.:

**Remark on Protest**          ☐ The additional search fees were accompanied by the applicant's protest and, where applicable,
the                                      payment of a protest fee..

                                  ☐ The additional search fees were accompanied by the applicant's protest but the applicable protest
                                      fee was not paid within the time limit specified in the invitation.

                                  ☐ No protest accompanied the payment of additional search fees.

Form PCT/ISA/210 (continuation of first sheet (2)) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4411952 A
- EP 431636 A
- US 5262227 A
- US 5741598 A
- JP 2000096010 A
- JP 2005186274 A